# DEMANDE DE BREVET EUROPEEN

(11) **EP 1 843 359 A1**
(43) Date de publication de la demande: **10.10.2007**
(21) Numéro de dépôt: 07006474.6
(22) Date de dépôt: 29.03.2007
(51) Int. Cl.: G11C 16/22

(54) **Procédé de sécurisation de blocs de données dans une mémoire programmable électriquement**

(30) Priorité: 07.04.2006 FR 0603074
(71) Demandeur: STMICROELECTRONICS SA, 92120 Montrouge (FR)
(72) Inventeur: Murillo, Laurent, 13013 Marseille (FR); Ganivet, Philippe, 13320 Bouc Bel Air (FR)
(74) Mandataire: Marchand, André

(57) **Abrégé**

L'invention concerne un procédé de sécurisation d'une zone mémoire (MZ) comprenant des blocs de données (Wk), dans lequel on associe au moins deux bits témoins (CB0, CB1) à chaque bloc de données. Le procédé comprend une étape de lecture des bits témoins (CB0, CB1) associés à un bloc de données actuel (Wk) destiné à être remplacé par le nouveau bloc de données, avant l'écriture d'un nouveau bloc de données (Wk') dans la zone mémoire. Une action de sécurisation de la zone mémoire est engagée si les deux bits témoins (CB0, CB1) ont la même valeur. A chaque écriture d'un nouveau bloc de données (Wk') dans la zone mémoire, des bits témoins (CB0', CB1') ayant des valeurs inverses l'une de l'autre sont écrits dans la zone mémoire. Application notamment à la sécurisation d'un compteur binaire.

## Description

La présente invention concerne un procédé de sécurisation d'une zone mémoire comprenant des blocs de données, ainsi qu'un circuit électronique comprenant des groupes de cellules mémoire recevant chacun un bloc de données, et des moyens pour exécuter une commande d'écriture d'un bloc de données dans un groupe de cellules mémoire.

La présente invention concerne notamment la sécurisation d'un compteur binaire implémenté sur circuit intégré, notamment les circuits intégrés pour compteurs kilométriques de véhicules automobiles.

La présente invention concerne également la sécurisation des circuits intégrés utilisés pour gérer des données de transaction, comme les circuits intégrés pour carte à puce de type porte-monnaie électronique, carte téléphonique, carte de transport, etc.

Les données de transaction ou de comptage ont généralement une valeur monétaire tangible, qu'il s'agisse de données de transaction permettant d'accéder à un service ou de données de comptage d'un compteur kilométrique permettant d'établir la valeur d'un véhicule. De ce fait, les circuits intégrés comprenant de telles données sont souvent la cible des fraudeurs qui tentent de falsifier ou de régénérer ces données.

Les mémoires utilisées pour stocker ce type de données sont des mémoires rémanentes généralement du type programmable et effaçable électriquement. Ainsi, un fraudeur souhaitant régénérer la valeur d'un compteur d'unités de transaction ou d'un compteur binaire tentera généralement d'effacer des cellules mémoire se trouvant dans l'état programmé pour que tout ou partie des unités du compteur soit remise à 0. La technique d'effacement la plus couramment utilisée est l'effacement collectif des cellules mémoire, en exposant la mémoire à un faisceau de particules, généralement un faisceau UV (faisceau de lumière ultraviolette). Une exposition aux UV a pour effet d'extraire des charges électriques des cellules mémoire et de les placer dans un état électrique vierge correspondant généralement, en lecture, à l'état effacé.

Une solution pour contrer ce type de fraude, décrite par EP 1 006 532, est de prévoir une cellule mémoire témoin qui est portée dans un état initial, effacé ou programmé, et est ensuite lue avec deux tensions de lecture afin de détecter si la cellule mémoire se trouve dans l'état initial ou dans un état intermédiaire correspondant à l'état UV. Cette solution présente l'inconvénient de nécessiter deux tensions de lecture, l'une étant une tension de lecture "standard" et l'autre permettant de détecter si la cellule mémoire est dans l'état UV.

De plus, cette solution ne permet pas de contrer certains types de fraudes comme la corruption du processus de lecture, permettant d'inhiber des mécanismes de protection intervenant au moment de la lecture des données, ou la corruption du processus d'écriture, permettant d'écrire des données falsifiées dans une mémoire.

Ainsi, un objectif de la présente invention est de perfectionner les procédés dé sécurisation de données basés sur l'utilisation d'une cellule mémoire témoin.

Un autre objectif de la présente invention est de sécuriser un compteur binaire d'une manière plus efficace que les procédés connus.

Ces objectifs sont atteints par la prévision d'un procédé de sécurisation d'une zone mémoire comprenant des blocs de données, comprenant les étapes consistant à associer au moins deux bits témoins à chaque bloc de données ; avant l'écriture d'un nouveau bloc de données dans la zone mémoire, lire dans la zone mémoire les bits témoins associés à un bloc de données actuel destiné à être remplacé par le nouveau bloc de données, et engager une action de sécurisation de la zone mémoire si les deux bits témoins ont la même valeur ; et à chaque écriture d'un nouveau bloc de données dans la zone mémoire, écrire simultanément dans la zone mémoire des bits témoins ayant des valeurs inverses l'une de l'autre.

Selon un mode de réalisation, chaque bit témoin écrit dans la zone mémoire pendant l'écriture d'un nouveau bloc de donnée a une valeur inverse de celle du bit témoin correspondant lu dans la zone mémoire avant l'écriture du nouveau bloc de données.

Selon un mode de réalisation, l'action de sécurisation comprend le fait d'empêcher l'écriture du nouveau bloc de données dans la zone mémoire.

Selon un mode de réalisation, l'action de sécurisation comprend la fourniture d'un signal d'erreur ou d'un message d'erreur.

Selon un mode de réalisation, les bits témoins associés à un bloc de données sont écrits dans des cellules mémoire qui sont contiguës à un groupe de cellules mémoire recevant le bloc de données associé.

Selon un mode de réalisation, une cellule mémoire recevant un bit témoin est agencée à une extrémité du groupe de cellules mémoire recevant le bloc de données associé et une cellule mémoire recevant l'autre bit témoin est agencée à une autre extrémité du groupe de cellules mémoires recevant le bloc de données associé.

Selon un mode de réalisation, le procédé comprend une étape d'initialisation de la zone mémoire consistant à écrire dans la zone mémoire des groupes d'au moins deux bits témoins associés chacun à un bloc de données, en conférant à deux bits témoins d'un même groupe des valeurs inverses l'une de l'autre.

L'invention concerne également un procédé de sécurisation d'une chaîne de bits dans une zone mémoire rémanente, comprenant les étapes consistant à décomposer la chaîne de bits en une pluralité de blocs de données, et sécuriser chaque bloc de données conformément au procédé de sécurisation d'une zone mémoire décrit ci-dessus.

Selon un mode de réalisation, la chaîne de bits forme un compteur binaire, et le procédé comprend les étapes consistant à lire simultanément dans la zone mémoire le bloc de données actuel et les deux bits témoins associés avant l'écriture d'un nouveau bloc de données dans la zone mémoire, et engager l'action de sécurisation de la zone mémoire si au moins l'une des deux conditions suivantes est rencontrée : 1) les deux bits témoins ont la même valeur, 2) la valeur du nouveau bloc de données n'est pas différente de la valeur du bloc de données actuel selon un sens de variation déterminé du compteur.

La présente invention concerne également un circuit électronique comprenant une zone mémoire sécurisée comprenant des groupes de cellules mémoire recevant chacun un bloc de données, des moyens pour exécuter une commande d'écriture d'un bloc de données dans un groupe de cellules mémoire désigné par la commande, dans lequel la zone mémoire comprend, pour chaque bloc de données, au moins deux cellules mémoire témoins associées au groupe de cellules mémoire recevant le bloc de données, le circuit comprenant des moyens de sécurisation agencés pour : avant l'écriture d'un nouveau bloc de données dans un groupe de cellules mémoire désigné par une commande, lire les cellules mémoire témoins associées au groupe de cellules mémoire, et engager une action de sécurisation de la zone mémoire si deux bits lus dans les cellules mémoire témoins ont la même valeur, et à chaque écriture d'un bloc de données dans un groupe de cellules mémoire désigné par une commande, écrire simultanément dans les cellules mémoire témoins associées au groupe de cellules mémoire au moins deux bits ayant des valeurs inverses l'une de l'autre.

Selon un mode de réalisation, les moyens de sécurisation sont agencés pour, à chaque écriture d'un bloc de données dans un groupe de cellules mémoire, écrire dans chaque cellule mémoire témoin associée au groupe de cellules mémoire, un bit ayant une valeur inverse de celle du bit lu dans la cellule mémoire témoin avant l'écriture du bloc de données.

Selon un mode de réalisation, les moyens de sécurisation sont agencés pour engager une action de sécurisation comprenant le fait d'empêcher l'écriture du bloc de données dans la zone mémoire.

Selon un mode de réalisation, les moyens de sécurisation sont agencés pour engager une action de sécurisation comprenant la fourniture d'un signal d'erreur ou d'un message d'erreur.

Selon un mode de réalisation, les cellules mémoire témoins sont contiguës au groupe de cellules mémoire recevant le bloc de données associé.

Selon un mode de réalisation, une cellule mémoire témoin est agencée à une extrémité du groupe de cellules mémoire associé et une cellule mémoire recevant l'autre bit témoin est agencée à une autre extrémité du groupe de cellules mémoires associé.

Selon un mode de réalisation, le circuit électronique comprend une chaîne de bits formant un compteur binaire, décomposée en une pluralité de blocs de données, et des moyens de gestion du compteur binaire incluant lesdits moyens de sécurisation.

Selon un mode de réalisation, les moyens de gestion du compteur binaire sont agencés pour : avant chaque écriture d'un nouveau bloc de données dans un groupe de cellules mémoire désigné par une commande, lire le groupe de cellules mémoire désigné par la commande et les cellules mémoire témoins associées au groupe de cellules mémoire, et engager l'action de sécurisation de la zone mémoire si au moins l'une des deux conditions suivantes est rencontrée : 1) deux bits présents dans les cellules mémoire témoins ont la même valeur, 2) la valeur du nouveau bloc de données n'est pas différente de la valeur actuelle du bloc de données lu dans le groupe de cellules mémoire, selon un sens de variation déterminé du compteur.

L'invention concerne également un circuit intégré sur semi-conducteur comprenant un circuit électronique selon l'invention.

L'invention concerne également une carte à puce comprenant un circuit intégré selon l'invention.

L'invention concerne également un compteur électronique comprenant un circuit intégré selon l'invention.

Ces objets, caractéristiques et avantages ainsi que d'autres de la présente invention seront exposés plus en détail dans la description suivante du procédé de l'invention et d'un exemple de réalisation d'un circuit électronique mettant en oeuvre ce procédé, faite à titre non limitatif en relation avec les figures jointes parmi lesquelles :
- la figure 1 représente schématiquement une zone mémoire classique comprenant une chaîne de bits formant un compteur binaire,
- la figure 2 illustre schématiquement l'application du procédé de l'invention à la chaîne de bits de la figure 1,
- la figure 3 représente l'architecture d'un circuit électronique comprenant une mémoire effaçable et programmable électriquement et des moyens de sécurisation selon l'invention, et
- la figure 4 est un organigramme illustrant la mise en oeuvre du procédé de l'invention dans le circuit de la figure 3.

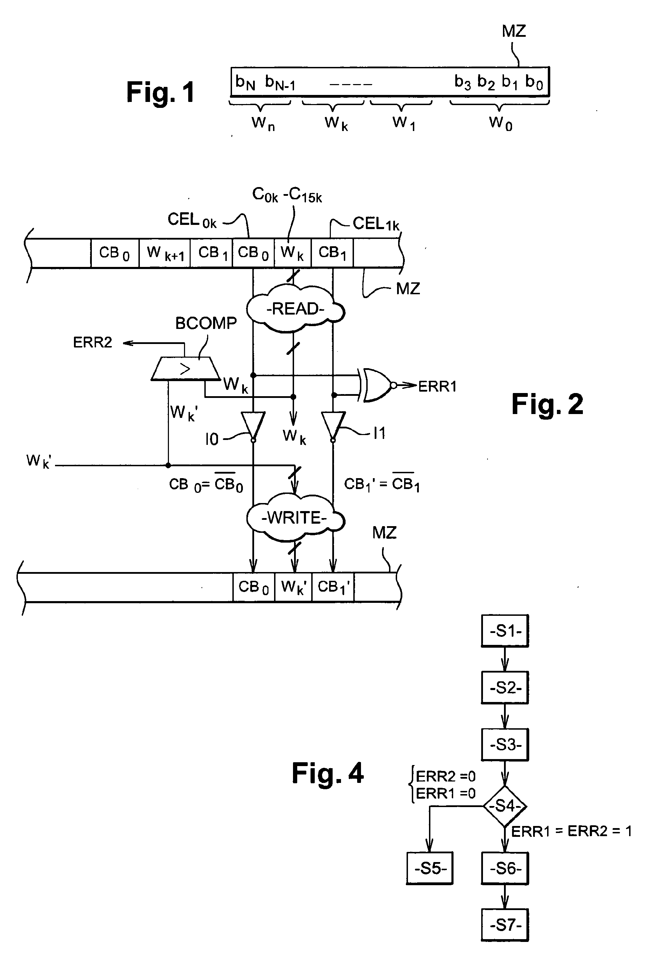

A titre d'exemple de mise en oeuvre du procédé de l'invention, considérons une chaîne de bits b0, b1, b3... bN telle que représenté en figure 1 et supposons que la chaîne de bits forme un compteur binaire dont le contenu doit être modifié de temps en temps pour revoir une nouvelle valeur de comptage. La chaîne de bits est mémorisée dans une zone mémoire MZ de type effaçable et programmable électriquement. La chaîne de bits est décomposée en une pluralité de mots ou blocs de données Wk de rang k (W0, W1,...,wk,...Wn) comprenant chacun un même nombre de bits, par exemple 16 bits, chaque bit étant mémorisé par une cellule mémoire.

A chaque rafraîchissement, un nouveau bloc de données doit être écrit dans la zone mémoire à la place d'un bloc de données précédent. Pour s'affranchir du risque de fraude consistant à écrire dans le compteur un bloc de données de valeur inférieure au bloc de données précédent (cas d'un compteur à valeurs croissantes), le nouveau bloc de données est comparé au bloc de données précédent et n'est écrit dans le compteur que s'il présente une valeur supérieure à ce dernier.

Par exemple, si la valeur actuelle du compteur est la suivante :

| Wn | | Wk | | W1 | W0 |
|---|---|---|---|---|---|
| 00000-0 | | 00111-1 | | 11111-1 | 11111-1 |

et si la valeur suivante du compteur est la valeur suivante :

| Wn | | Wk' | | W1 | W0 |
|---|---|---|---|---|---|
| 00000-0 | | 10001-1 | | 11111-1 | 11111-1 |

le bloc de données Wk' n'est écrit dans le compteur que si sa valeur est supérieure à la valeur précédente Wk.

Outre le risque d'un effacement global de la zone mémoire aux UV, le risque de fraude du compteur comprend également le risque de corruption du processus de lecture du bloc de données précédent Wk afin que celui-ci soit lu comme étant inférieur au bloc de données suivant Wk' même lorsque cela n'est pas le cas, ce qui permet de diminuer la valeur de comptage présente dans le compteur. Le risque de fraude comprend également le risque de corruption du processus d'écriture du nouveau bloc de données, pour écrire une valeur de comptage inférieure après que l'étape de comparaison est effectuée.

Ainsi, la simple comparaison de la valeur précédente du bloc de données à rafraîchir avant l'écriture du bloc de données dans la zone mémoire n'est pas suffisante pour s'affranchir du risque de fraude.

Selon l'invention et comme illustré en figure 2, on ajoute à la zone mémoire MZ des cellules mémoire témoins de manière qu'à chaque bloc de données soit associés au moins deux bits témoins CB0, CB1. Comme représenté, des cellules mémoire CEL0k, CEL1k recevant les bits témoins CB0, CB1 sont préférentiellement ajoutées à droite et à gauche de chaque emplacement d'un bloc de donnée, formé par un groupe de cellules mémoire C0k-C15k.

Avant d'être mis en service, le compteur est initialisé de manière que les deux bits témoins CB0, CB1 associés à chaque bloc de données présentent des valeurs opposées, soit 0 et 1 ou 1 et 0. Cette opération est effectuée dans un mode de test et ne peut plus être réalisée une fois le compteur mis en service.

Lorsque le bloc de données Wk doit être remplacé par le nouveau bloc de données Wk', le bloc de données Wk ainsi que les bits témoins CB0, CB1 associés à ce bloc sont lus, comme représenté schématiquement par une étape "READ".

Les deux bits témoins CB0, CB1 sont comparés l'un à l'autre pour vérifier qu'ils sont différents, par exemple au moyen d'une porte XOR (OU EXCLUSIF) qui fournit un signal d'erreur ERR1 égal à 1 si les deux bits sont différents ou égal à 0 (valeur active) si les deux bits sont égaux.

Simultanément, le nouveau bloc de données Wk' est comparé au bloc de données Wk lu dans la zone mémoire, par exemple au moyen d'un comparateur binaire BCOMP qui fournit un signal d'erreur ERR2 égal à 1 si la valeur du bloc de données Wk' est supérieure à la valeur du bloc de données Wk, ou égal à 0 (valeur active) dans le cas contraire.

Si l'un ou l'autre des signaux d'erreur ERR1, ERR2 est égal à 0, l'opération d'écriture est annulée. Sinon, l'opération d'écriture du bloc de données Wk' est effectuée. De façon optionnelle mais avantageuse, l'écriture du bloc de données Wk' est accompagnée de l'écriture dans les deux cellules mémoire témoins de deux nouveaux bits témoins CBO', CB1' ayant chacun une valeur inverse de celle du bit témoin correspondant CB0, CB1 précédemment lu dans la zone mémoire (CB0'=/CB0, CB1'=/CB1). Les bits témoins CBO', CB1' sont par exemple fournis par des portes inverseuses I0, I1 qui reçoivent en entrée les bits témoins CB0, CB1, respectivement. Cette étape de réécriture des deux bits témoins en inversant leurs valeurs respectives permet de rafraîchir les cellules mémoires témoins et de s'affranchir d'un vieillissement prématuré de celles-ci ou d'une altération des valeurs des bits témoins par phénomène de perte de charge ("retention loss"), tout en conservant la dualité de valeurs entre les deux bits témoins.

Le procédé selon l'invention offre ainsi une triple protection :
1) une protection contre une corruption du processus de lecture, qui sera détectée par le fait que les bits témoins présenteront la même valeur lorsqu'ils seront lus,
2) une protection contre une corruption du processus d'écriture, qui sera détectée par le fait que les bits témoins présenteront la même valeur lorsqu'ils seront écrit, et donc également lorsqu'ils seront lus ultérieurement,
3) une protection contre un effacement global de la zone mémoire, qui sera également détecté par le fait que les bits témoins présenteront la même valeur lorsqu'ils seront lus.

De ce fait, le procédé de l'invention peut être appliqué à la sécurisation d'une mémoire dans diverses applications autres que la gestion d'un compteur binaire, dans lesquelles l'étape de comparaison du nouveau bloc de données Wk' et du précédent bloc de données Wk n'est pas mise en oeuvre.

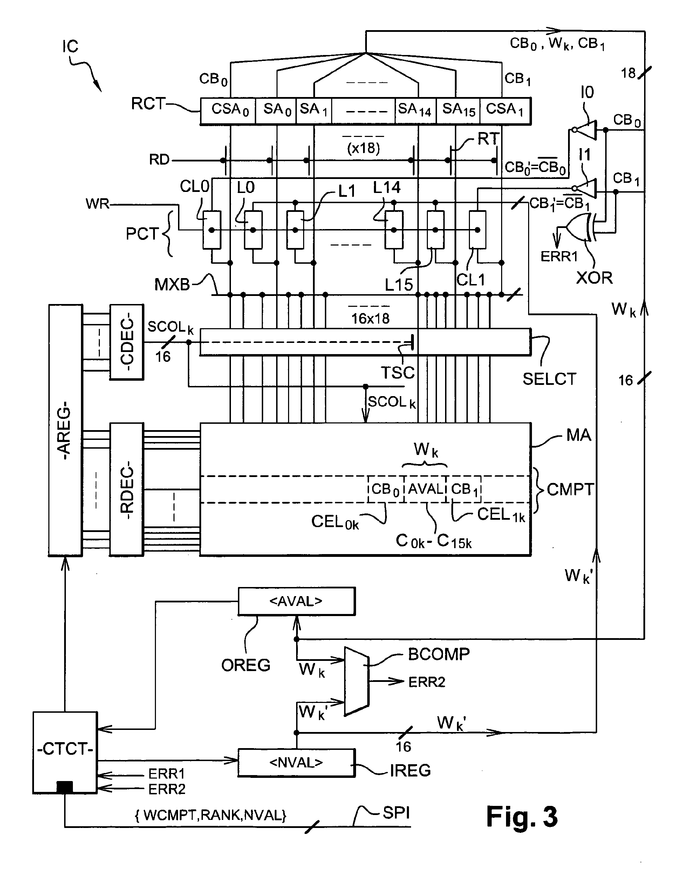

La figure 3 illustre un exemple de mise en oeuvre du procédé de l'invention dans un circuit intégré IC comprenant une mémoire effaçable et programmable électriquement de type EEPROM. La mémoire comprend classiquement un plan mémoire MA, un décodeur de ligne RDEC assurant la sélection des lignes de mots du plan mémoire, un décodeur de colonne CDEC assurant la sélection de groupes de lignes de bits du plan mémoire (colonnes), un circuit de programmation PCT et un circuit de lecture RCT.

La mémoire est conçue ici pour être accessible en lecture et en écriture par bloc de données de 16 bits, soit par paire d'octets. Dans le plan mémoire MA, une ligne de mots (page physique de la mémoire) est réservée à la gestion d'un compteur binaire CMPT.

Chaque ligne de mots comprend par exemple 16 blocs de données de 16 bits chacun. Au lieu de prévoir 16x16 soit 256 cellules mémoire par page physique, on prévoit ici 16x18 soit 288 cellules mémoire dans chaque ligne de mots, soit seize colonnes de dix-huit lignes de bits chacune, afin d'associer deux cellules mémoire témoins CEL0k, CEL1k à chaque bloc de données Wk contenu dans seize cellules mémoire C0k-C15k.

De façon correspondante, le circuit de lecture RCT comprend dix-huit amplificateurs de lecture au lieu de seize. Plus particulièrement, seize amplificateurs de lecture SA0-SA15 sont prévus pour lire simultanément un bloc de données, un amplificateur de lecture CSA0 est prévu pour lire le premier bit témoin CB0 du bloc de données et un amplificateur de lecture CSA1 est prévu pour lire le second bit témoin CB1 du bloc de données. Les amplificateurs de lecture CSA0, SA0-SA15, CSA1 sont reliés au plan mémoire par l'intermédiaire de transistors de lecture RT, d'un bus de multiplexage MXB et d'un circuit de sélection SELCT reliant le bus MXB aux lignes de bits du plan mémoire. Les transistors de lecture RT sont rendus passant par un signal RD qui est actif en mode lecture du plan mémoire.

Toujours de façon correspondante, le circuit de programmation PCT comprend dix-huit verrous de programmation au lieu de seize. Seize verrous de programmation L0-L15 sont prévus pour programmer simultanément seize bits dans un bloc de données, un verrou de programmation CL0 est prévu pour programmer le premier bit témoin CB0 associé au bloc de données et un verrou de programmation CL1 est prévu pour programmer le second bit témoin CB1 associé au bloc de données. Les verrous de programmation CL0, L0-L15, CL1 sont reliés au plan mémoire par l'intermédiaire du bus de multiplexage MXB et du circuit de sélection SELCT. Ils sont activés par un signal WR qui est actif en mode écriture du plan mémoire.

Le circuit de sélection SELCT comprend seize groupes de dix-huit transistors de sélection de colonne TSC pilotés par des signaux de sélection de colonnes SCOLk (k= 0 à 15) fournis par le décodeur CDEC, chacun des signaux SCOLk étant dédié à l'activation d'un groupe de transistors de sélection de colonne TSC. Ainsi, en mode lecture, dix-huit lignes de bits d'une colonne parmi les 16x18 lignes de bits du plan mémoire sont reliées aux amplificateurs de lecture CSA0, SA0-SA15, CSA1 lorsque l'un des signaux SCOLk sélectionne la colonne en mettant dans l'état passant les transistors TSC affectés à la sélection de cette colonne. De même, en mode écriture, dix-huit lignes de bits d'une colonne parmi les 16x18 lignes de bits du plan mémoire sont reliées aux verrous CL0, L0-L15, CL1 lorsque l'un des signaux SCOLk sélectionne la colonne en mettant dans l'état passant les transistors TSC correspondants.

Le circuit intégré comprend également un circuit de contrôle CTCT, un registre d'adresse AREG à entrée série et sortie parallèle, un registre de données d'entrée IREG à entrée série et sortie parallèle, un registre de données de sortie OREG à entrée parallèle et sortie série. Sont également prévus les éléments décrits plus haut permettant la mise en oeuvre du procédé de l'invention, à savoir les portes inverseuses I0, I1, la porte XOR dont la sortie fournit le signal ERR1 et le comparateur BCOMP dont la sortie fournit le signal ERR2.

Le circuit de contrôle CTCT, par exemple un séquenceur à logique câblée, gère l'ensemble des éléments de la mémoire pour exécuter des commandes de lecture et d'écriture du plan mémoire. Il comprend une entrée/sortie série reliée à un bus série de type SPI (Serial Peripheral Interface) au moyen de laquelle il reçoit des commandes de lecture ou d'écriture et notamment une commande spécifique WRITECMPT d'écriture du compteur CMPT, du type :
<CODE(WRITECMPT), RANK, NVAL>,
comprenant le code de la commande, le rang du bloc de données à écrire dans le compteur (allant ici de 0 à 15) et la nouvelle valeur à écrire NVAL.

Le circuit CTCT comporte une sortie interne reliée à l'entrée série du registre IREG, une autre sortie interne reliée à l'entrée série du registre AREG et une entrée interne reliée à la sortie série du registre OREG.

La sortie parallèle du registre IREG, de 16 bits, est reliée d'une part à une première entrée du comparateur BCOMP et d'autre part à l'entrée du circuit de programmation. Plus particulièrement, chaque fil de sortie véhiculant un bit de donnée présent dans le registre IREG est relié à l'un des verrous de programmation L0-L15.

Le circuit de lecture RCT comporte une sortie parallèle de 18 bits correspondant à la juxtaposition des sorties des amplificateurs de lecture SA0-SA15 et des amplificateurs de lecture CSA0, CSA1.

Les bits témoins CB0, CB1 fournis par les amplificateurs de lecture CSA0, CSA1 sont envoyés d'une part sur les entrées des portes inverseuses I0, I1, et d'autre part sur les entrées de la porte XOR. La sortie de la porte I0, fournissant le bit témoin CB0'=/CB0, est appliquée à l'entrée du verrou CL0 tandis que la sortie de la porte I1, fournissant le bit témoin CB1'=/CB1, est appliquée à l'entrée du verrou CL1.

Les seize bits de données fournis par les amplificateurs de lecture SA0-SA15 forment un bloc de données Wk qui est envoyé d'une part sur une seconde entrée du comparateur BCOMP et d'autre part sur l'entrée parallèle du registre OREG.

Le fonctionnement du circuit intégré IC en réponse à une commande d'écriture du compteur reçue sur le bus SPI comprend les étapes suivantes, illustrées par l'organigramme de la figure 4 :
**Etape S1)** réception d'une commande WRITECMPT: le circuit de contrôle CTCT reçoit et décode la commande, puis enregistre la nouvelle valeur reçue NVAL dans le registre IREG, formant le bloc de données Wk' à écrire.
**Etape S2**) préparation de la lecture du bloc de données Wk : le circuit CTCT charge dans le registre d'adresse AREG une adresse de sélection du bloc de données du compteur CMPT désignée par le paramètre RANK présent dans la commande. Cette adresse comprend des bits de poids fort désignant la ligne de mots (page physique du plan mémoire recevant le compteur) qui sont appliqués au décodeur de ligne RDEC, et des bits de poids faible désignant la colonne du plan mémoire dans laquelle se trouve le bloc de données visé, qui sont appliqués au décodeur de colonne CDEC.
**Etape S3**) lecture du bloc de données Wk : le circuit CTCT applique une tension de lecture au plan mémoire, active tous les amplificateurs de lecture du circuit de lecture RCT. La valeur actuelle AVAL du bloc de données Wk devant être remplacée par la valeur NVAL du nouveau bloc de données Wk' est alors appliquée au comparateur BCOMP (celui-ci recevant sur son autre entrée la valeur NVAL présente dans le registre IREG) et les valeurs actuelles des bits témoins CB0, CB1 sont appliquées à la porte XOR. Optionnellement, le circuit CTCT charge le bloc Wk dans le registre de sortie OREG pour la retransmettre ultérieurement sur le bus SPI en cas de refus d'écriture. Le bit d'erreur ERR1 passe à 0 (valeur active) si les bits CB0, CB1 sont égaux et le bit d'erreur ERR2 passe à 0 si la nouvelle valeur NVAL n'est pas supérieure à la valeur actuelle AVAL du bloc de données Wk (on suppose comme précédemment que le compteur est géré par valeurs croissantes).
**Etape S4**) test des signaux d'erreur : le circuit CTCT teste les signaux d'erreur ERR1, ERR2. Si au moins l'un des deux signaux est égal à 0, le circuit CTCT passe à l'étape S5 décrite ci-après. Sinon, le circuit CTCT passe à l'étape S6.
**Etape S5**) le circuit CTCT refuse d'exécuter la commande d'écriture de la valeur NVAL et renvoie sur le bus SPI un message d'erreur. Optionnellement, le type d'erreur (ERR1 ou ERR2) est signalé. Toujours de façon optionnelle, le message d'erreur est accompagné de la valeur AVAL (à titre de justificatif du refus) si le refus est imputable au passage à 0 du signal ERR2.
**Etape S6**) le circuit CTCT active les verrous de programmation L0-L15 et CL0, CL1 de manière que le bloc de données Wk' de valeur NVAL du bloc de données soit chargée dans les verrous L0-L15, et que les bits témoins inversés CB0'=/CB0, CB1'=/CB1 fournis par les portes I1, I2 soient chargés dans les verrous CL0, CL1. Le circuit de contrôle applique ensuite aux décodeurs RDEC, CDEC et au plan mémoire MA les tensions nécessaires à l'effacement des cellules mémoire contenant le bloc de données sélectionné, puis applique aux décodeurs RDEC, CDEC et au plan mémoire MA les tensions nécessaires à la programmation des cellules mémoire contenant le bloc de données sélectionné (seules les cellules mémoire devant recevoir une valeur logique de programmation, par exemple 1, étant programmées).
**Etape S7**) le circuit CTCT renvoie sur le bus SPI une confirmation d'écriture comprenant optionnellement la valeur AVAL ayant été remplacée par la valeur NVAL.

Il apparaîtra clairement à l'homme de l'art que la présente invention est susceptible de diverses variantes de réalisation, notamment en ce qui concerne la taille des blocs de données, le nombre de bits témoins qui sont associés à chaque bloc de données (limité à deux dans un souci de simplicité dans l'exemple décrit ci-dessus), les moyens de contrôle des bits témoins. Notamment, le procédé selon l'invention peut être exécuté par un microprocesseur sous le contrôle d'un programme, bien que cette solution présente un niveau de sécurité plus faible en raison des risques de fraude portant sur le programme lui-même (le niveau de sécurité étant ainsi maximal lorsque l'implémentation est faite avec des circuits à logique câblée).

D'autre part, le procédé de l'invention est applicable à tout type de plan mémoire. Notamment, bien que les cellules mémoire témoins recevant les bits témoins CB0 CB1 sont préférentiellement disposées le long d'une ligne de mots, respectivement à droite et à gauche du groupe de cellules mémoire recevant le bloc de données associé, d'autres agencements peuvent être prévus. Par exemple, une région du plan mémoire peut être réservée aux cellules mémoires témoins, à raison d'une ou de plusieurs paires par bloc de données. Il est toutefois préférable de conserver les cellules mémoires témoins d'un bloc de données à côté des cellules mémoire recevant le bloc de données concerné, pour contrer plus efficacement les attaques localisées ne concernant qu'une partie du plan mémoire, à moins que l'architecture de la mémoire soit basée sur un entrelacement de cellules mémoire (mémoires FLASH notamment).

La présente invention est également susceptible de diverses applications. La présente invention est notamment applicable à la réalisation de cartes à puce et de circuits intégrés pour carte à puce contenant un compteur d'unités de transaction (qui peut aussi être un compteur à valeurs décroissantes, ou "décompteur").

De plus, comme on l'a indiqué ci-dessus, la prévision des bits témoins offre une triple protection et permet de détecter, en sus d'une corruption du processus d'écriture ou du processus de lecture, un effacement global du plan mémoire (par exemple un effacement UV). De ce fait, la présente invention peut être utilisée pour la protection d'un plan mémoire en écriture et en lecture, indépendamment de l'application à la gestion d'un compteur binaire.

## Revendications

1. Procédé de sécurisation d'une zone mémoire (MZ, MA, CMPT) comprenant des blocs de données (Wk), **caractérisé en ce qu'**il comprend les étapes consistant à :
- associer au moins deux bits témoins (CB0, CB1) à chaque bloc de données,
- avant l'écriture d'un nouveau bloc de données (Wk') dans la zone mémoire, lire dans la zone mémoire les bits témoins (CB0, CB1) associés à un bloc de données actuel (Wk) destiné à être remplacé par le nouveau bloc de données, et engager une action de sécurisation de la zone mémoire si les deux bits témoins (CB0, CB1) ont la même valeur, et
- à chaque écriture d'un nouveau bloc de données (Wk') dans la zone mémoire, écrire simultanément dans la zone mémoire des bits témoins (CB0', CB1') ayant des valeurs inverses l'une de l'autre.

2. Procédé selon la revendication 1, dans lequel chaque bit témoin (CB0', CB1') écrit dans la zone mémoire pendant l'écriture d'un nouveau bloc de donnée (Wk') a une valeur inverse de celle du bit témoin correspondant (CB0, CB1) lu dans la zone mémoire avant l'écriture du nouveau bloc de données.

3. Procédé selon l'une des revendications 1 et 2, dans lequel l'action de sécurisation comprend le fait d'empêcher l'écriture du nouveau bloc de données (Wk') dans la zone mémoire.

4. Procédé selon l'une des revendications 1 à 3, dans lequel l'action de sécurisation comprend la fourniture d'un signal d'erreur (ERR1, ERR2) ou d'un message d'erreur.

5. Procédé selon l'une des revendications 1 à 4, dans lequel les bits témoins (CB0, CB1) associés à un bloc de données (Wk) sont écrits dans des cellules mémoire (CEL0k, CEL1k) qui sont contiguës à un groupe de cellules mémoire (C0k-C15k) recevant le bloc de données associé.

6. Procédé selon l'une des revendications 1 à 5, dans lequel une cellule mémoire (CEL0k) recevant un bit témoin (CB0) est agencée à une extrémité du groupe de cellules mémoire (C0k-C15k) recevant le bloc de données associé (Wk) et une cellule mémoire (CEL1k) recevant l'autre bit témoin (CB1) est agencée à une autre extrémité du groupe de cellules mémoires (C0k-C15k) recevant le bloc de données associé.

7. Procédé selon l'une des revendications 1 à 6, comprenant une étape d'initialisation de la zone mémoire consistant à écrire dans la zone mémoire des groupes d'au moins deux bits témoins (CB0, CB1) associés chacun à un bloc de données, en conférant à deux bits témoins d'un même groupe des valeurs inverses l'une de l'autre.

8. Procédé de sécurisation d'une chaîne de bits dans une zone mémoire rémanente (MZ, MA, CMPT), **caractérisé en ce qu'**il comprend les étapes consistant à :
- décomposer la chaîne de bits en une pluralité de blocs de données (Wk), et
- sécuriser chaque bloc de données conformément au procédé selon l'une des revendications 1 à 7.

9. Procédé selon la revendication 8, dans lequel la chaîne de bits forme un compteur binaire (CMPT), et comprenant les étapes consistant à :
- avant l'écriture d'un nouveau bloc de données (Wk') dans la zone mémoire, lire simultanément dans la zone mémoire le bloc de données actuel (Wk) et les deux bits témoins associés (CB0, CB1), et
- engager l'action de sécurisation de la zone mémoire si au moins l'une des deux conditions suivantes est rencontrée :
- les deux bits témoins (CB0, CB1) ont la même valeur,
- la valeur du nouveau bloc de données (Wk') n'est pas différente de la valeur du bloc de données actuel (Wk) selon un sens de variation déterminé du compteur.

10. Circuit électronique comprenant :
- une zone mémoire sécurisée (MZ, MA, CMPT) comprenant des groupes de cellules mémoire recevant chacun un bloc de données,
- des moyens pour exécuter (CTCT) une commande d'écriture d'un bloc de données dans un groupe de cellules mémoire désigné par la commande,
**caractérisé en ce que** la zone mémoire comprend, pour chaque bloc de données (Wk), au moins deux cellules mémoire témoins (CEL0k, CEL1k) associées au groupe de cellules mémoire (C0k-C15k) recevant le bloc de données,
et **en ce qu'**il comprend des moyens de sécurisation (CTCT, BCOMP, XOR, I0, I1) agencés pour :
- avant l'écriture d'un nouveau bloc de données (Wk') dans un groupe de cellules mémoire désigné par une commande, lire les cellules mémoire témoins (CEL0k, CEL1k) associées au groupe de cellules mémoire, et engager une action de sécurisation de la zone mémoire si deux bits lus dans les cellules mémoire témoins ont la même valeur, et
- à chaque écriture d'un bloc de données dans un groupe de cellules mémoire désigné par une commande, écrire simultanément dans les cellules mémoire témoins (CEL0k, CEL1k) associées au groupe de cellules mémoire (C0k-C15k) au moins deux bits (CB0', CB1') ayant des valeurs inverses l'une de l'autre.

11. Circuit électronique selon la revendication 10, dans lequel les moyens de sécurisation sont agencés pour, à chaque écriture d'un bloc de données dans un groupe de cellules mémoire, écrire dans chaque cellule mémoire témoin (CEL0k-CEL1k) associée au groupe de cellules mémoire, un bit (CB0', CB1') ayant une valeur inverse de celle du bit (CB0, CB1) lu dans la cellule mémoire témoin avant l'écriture du bloc de données.

12. Circuit électronique selon l'une des revendications 10 et 11, dans lequel les moyens de sécurisation sont agencés pour engager une action de sécurisation comprenant le fait d'empêcher l'écriture du bloc de données dans la zone mémoire.

13. Circuit électronique selon l'une des revendications 10 à 12, dans lequel les moyens de sécurisation sont agencés pour engager une action de sécurisation comprenant la fourniture d'un signal d'erreur (ERR1, ERR2) ou d'un message d'erreur.

14. Circuit électronique selon l'une des revendications 10 à 13, dans lequel les cellules mémoire témoins (CEL0k-CEL1k) sont contiguës au groupe de cellules mémoire (C0k-C15k) recevant le bloc de données associé.

15. Circuit électronique selon l'une des revendications 10 à 14, dans lequel une cellule mémoire témoin (CEL0k) est agencée à une extrémité du groupe de cellules mémoire associé (C0k-C15k) et une cellule mémoire (CEL1k) recevant l'autre bit témoin est agencée à une autre extrémité du groupe de cellules mémoires associé.

16. Circuit électronique selon l'une des revendications 10 à 15, comprenant une chaîne de bits formant un compteur binaire (CMPT), décomposée en une pluralité de blocs de données (Wk), et des moyens (CTCT) de gestion du compteur binaire incluant lesdits moyens de sécurisation.

17. Circuit électronique selon la revendication 16, dans lequel les moyens (COk-C15k) de gestion du compteur binaire (CMPT) sont agencés pour :
- avant chaque écriture d'un nouveau bloc de données (Wk') dans un groupe de cellules mémoire désigné par une commande, lire le groupe de cellules mémoire désigné par la commande et les cellules mémoire témoins associées au groupe de cellules mémoire, et
- engager l'action de sécurisation de la zone mémoire si au moins l'une des deux conditions suivantes est rencontrée :
- deux bits présents (CB0, CB1) dans les cellules mémoire témoins ont la même valeur,
- la valeur (NVAL) du nouveau bloc de données (Wk') n'est pas différente de la valeur actuelle (AVAL) du bloc de données lu dans le groupe de cellules mémoire, selon un sens de variation déterminé du compteur.

18. Circuit intégré sur semi-conducteur comprenant un circuit électronique selon l'une des revendications 10 à 17.

19. Carte à puce comprenant un circuit intégré selon la revendication 18.

20. Compteur électronique comprenant un circuit intégré selon la revendication 18.
